# EUROPEAN PATENT SPECIFICATION

(11) **EP 1 763 118 B1**
(45) Date of publication and mention of the grant of the patent: **11.05.2011**
(21) Application number: 06120259.4
(22) Date of filing: 07.09.2006
(51) Int. Cl.: H02B 1/28

(54) **Protective element and arrangement for reducing magnetic fields**
Schutzelement und Vorrichtung zur Reduktion der magnetischen Felder
Elément de protection et dispositif d'atténuation de champs magnétiques

(30) Priority: 09.09.2005 FI 20055485
(43) Date of publication of application: 14.03.2007
(73) Proprietor: Oy Elkamo Ab, 68600 Pietarsaari (FI)
(72) Inventor: Pihlajamaa, Jouko, 68620, Pietarsaari (FI); Teirikangas, Hannu, 67100, Kokkola (FI); Björk, Guy, 68600 Jakobstad (FI); Keikko, Tommi, 33720, Tampere (FI)
(74) Representative: Niemi, Hakan Henrik

(56) References cited:
- DE-A1- 3 306 530
- FR-A- 2 235 551

## Description

### BACKGROUND OF THE INVENTION

The invention relates to magnetic fields appearing in connection with electrical devices and particularly to reducing magnetic fields appearing in connection with electrical cabinets.

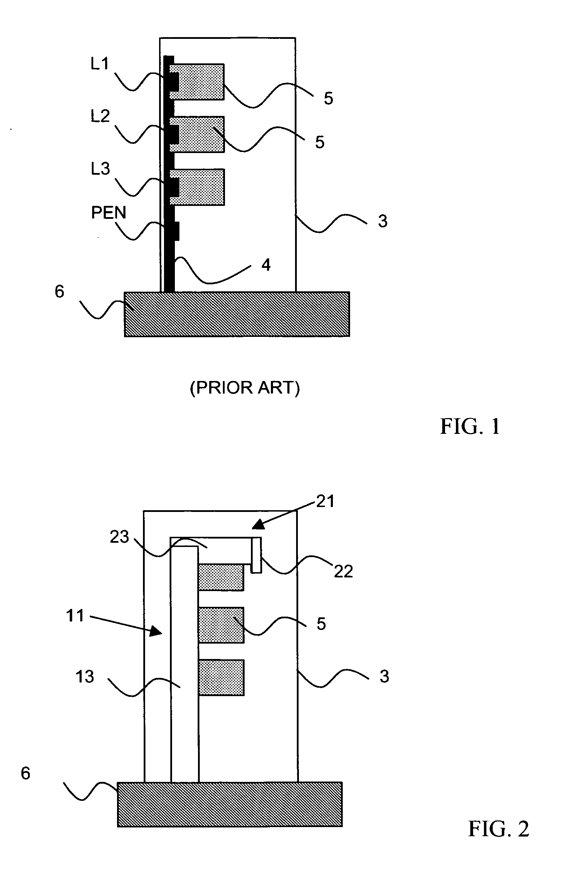

In prior art attempts have been made to reduce the effect of magnetic fields by means of enclosures. Figure 1 shows a prior art electrical cabinet. In this solution the electrical cabinet is provided with a housing part 3 aimed at reducing the effect of the magnetic field. The housing is made of metal and comprises a sealable door opening (not shown) through which coupling and maintenance works can be performed. The housing part 3 encloses fittings 5, such as distribution fuses and connectors, fixed to a frame part 4. The housing part 3 is mounted to a base 6.

The document DE 101 05 993 A is also disclosing some protective elements placed in an electrical cabinet.

A primary source of magnetic fields in electric power distribution cabinets, such as cable distribution cabinets, is a bus-bar system that feeds outputs. A cable distribution cabinet employs a rated current of 630A, for example. Those working close to the distribution cabinets may be subjected to magnetic fields of such magnitude that the operational values given in a directive on the minimum requirements set for occupational safety and health are exceeded.

Moreover, devices in the vicinity of electric power distribution cabinets have sometimes been subjected to interference that has been assumed to originate from a magnetic field caused by the cabinets.

### SUMMARY OF THE INVENTION

It is therefore an object of the invention to provide an electrical power distribution cabinet to allow the above problems caused by magnetic fields to be alleviated. The object of the invention is achieved by an electrical power distribution cabinet according to claim 1. The preferred embodiments of the invention are disclosed in the dependent claims.

The basic idea of the invention is that between the fittings of an electric power distribution cabinet and the cabinet housing part, i.e. the enclosure, and separate from the housing part there is provided a protective element that reduces magnetic fields. The protective element reduces magnetic fields by providing a structure that allows the protective element to be placed in the vicinity of the fittings in such a way that the cabinet coupling and maintenance works can be carried out even in a case in which the protective element is in attachment with the cabinet.

An advantage of the arrangement and protective element of the invention is that compared with prior art it allows magnetic fields to be reduced to a substantially lower level. The structure of the protective element does not enclose the fittings entirely but leaves the front part partly open. This novel protective element provides a good protection against magnetic fields also when used without the cabinet enclosure and with the cabinet door open. Consequently, this new magnetic field shield allows even housings made of non-conductive or non-magnetic materials to be used.

One aspect of the invention is to provide a protective element arranged to be placed between the fittings and the housing part, the element comprising a rear portion behind the fittings and an upper portion extending at least partly over the fittings.

Another aspect of the invention is to provide a protective element in which the upper portion of the protective element comprises a downward bent front portion.

Yet another aspect of the invention is to provide a protective element in which the upper portion of the protective element comprises downward bent side portions.

Yet another aspect of the invention is to provide a protective element in which the rear portion of the protective element comprises forward bent side portions.

Yet another aspect of the invention is to provide a protective element, the protective element being made of one or more bent pieces.

Yet another aspect of the invention is to provide a protective element, the protective element being made of an aluminium plate.

Yet another aspect of the invention is to provide an arrangement for reducing magnetic fields by a metal protective element placed behind the fittings, between the cabinet housing part and the fittings, the element comprising a rear portion behind the fittings and an upper portion extending at least partly over the fittings.

Yet another aspect of the invention is to provide an arrangement for reducing magnetic fields in which arrangement the upper portion of the protective element comprises a horizontal portion and a downward oriented portion.

Yet another aspect of the invention is to provide an arrangement for reducing magnetic fields, in which arrangement the rear portion and the upper portion of the protective element comprise side portions extending at least partly to the sides of the fittings.

Yet another aspect of the invention is to provide an arrangement for reducing magnetic fields, in which arrangement on the front side, down between the cabinet enclosure and the fittings, there is provided a protective metal front side element reducing the magnetic field.

According to the invention the protective element consist of one piece. The piece may be taken from a metal plate, such as an aluminium plate, by appropriate methods. The shape of the piece is designed so as to allow the piece to be bent into a protective element having a rear portion and an upper portion. The upper portion comprises a downward bent front portion. The rear portion and the upper portion may further comprise side portions at least partly extending over the fittings. The protective element thus functions not only as a shield for magnetic fields but also as a contact shield.

With the protective element bent from one plate, the different portions do not need to be joined together by welding, for example, which might cause changes to some of the dimensions. A protective element made of one piece conducts uniformly in different areas and therefore provides better protection against magnetic fields.

According to an aspect of the invention at the initial stage of manufacture the protective element may be cross-shaped, for example, thereby providing a bendable element that can be bent at the top and on the sides. Since the sides of the protective element are also bendable, a contact shield is provided not only for the back and the upper portion but also for the sides.

According to an aspect of the invention the protective element is an additional shield that can be attached to an ordinary prior art structure and fixed to the electrical cabinet, when additional protection against magnetic fields is needed.

The principles according to the invention for reducing magnetic fields may be applied not only to cable distribution cabinets but also to other power distribution cabinets. Comparison made between measured magnetic fields shows that this novel structure for a magnetic field shield allows considerably low magnetic field values to be achieved, even without the housing of the power distribution cabinet, such as a cable distribution cabinet. This allows for more freedom in the design of electrical cabinets, because they may be devised as structures separate from the parts inside the cabinets.

The protective element and the housing part of the electrical cabinet may be used for providing a doubled protective structure against magnetic fields. It is also possible to arrange the frame part of the electrical cabinet directly to the protective element, the electrical cabinet being in this case equipped and directly connected to the protective element of the invention.

The shape of the housing part of the electrical cabinet can be freely chosen, if the cabling and the fittings are not fixed directly to the frame attached to the housing part of the electrical cabinet. In this case, once the electrical cabinet is coupled, the housing part of the cabinet can be directly lifted over the fittings and possibly locked to the cabinet base, for example. Should the cabinet become subject to vandalism, such as graffiti-daubing, the housing part can be replaced by another, clean housing part. The damaged housing part can then be taken to a specific site for repair or service.

### BRIEF DESCRIPTION OF THE FIGURES

In the following, the invention will be discussed in greater detail with reference to the preferred embodiments and the accompanying drawings, in which
Figure 1 illustrates a prior art electrical cabinet;
Figure 2 illustrates a structure of the invention inside an electrical cabinet;
Figure 3 is a side view of a protective element of the invention;
Figure 4 is a partly cross-sectional view of a protective element of Figure 4 and a lower shield;
Figure 5 is a front view of the protective element of Figure 3 in its unbended form;
Figure 6 shows the lower shield of Figure 4 in its unbended form; and
Figure 7 is a side view of the lower shield of Figure 4 in its bended from.

### DETAILED DESCRIPTION OF THE INVENTION

Reference is made to Figure 2, which shows a protective element according to a first aspect of the arrangement of the invention placed inside an electrical cabinet. In the figure there is a housing part 3 placed onto a base 6. In this solution a frame part 4 shown in Figure 1 is fixed to the base 6 as a structure separate from the housing part. Here the frame part is covered by the protective element. This means that the housing part 3 can be replaced by another housing part without the need to detach the couplings of the electrical cabinet. Fittings 5, such as distribution fuses and connectors, are arranged to a bus-bar system. The protective element is placed behind the fittings 5, between the housing part 3 and the fittings 5 of the cabinet. Since the protective element is placed as close as possible to the fittings 5, it reduces the magnetic field efficiently. The protective element may be made of metal, such as aluminium, or steel. The protective element of Figure 2 comprises a rear portion 11 arranged behind the fittings and an upper portion 21 extending at least partly over the fittings. The rear portion 11 is bent on both sides of the fittings with side portions 13 so that it at least partly covers the sides of the fittings. The upper portion 21 of the protective element is bent on both sides of the fittings by means of side portions 23 so that it also at least partly covers the fittings. The rear portion 11 and the upper portion 21 of the protective element thus provide not only protection against the magnetic field but also a contract protection at the back, the top and partly on the sides.

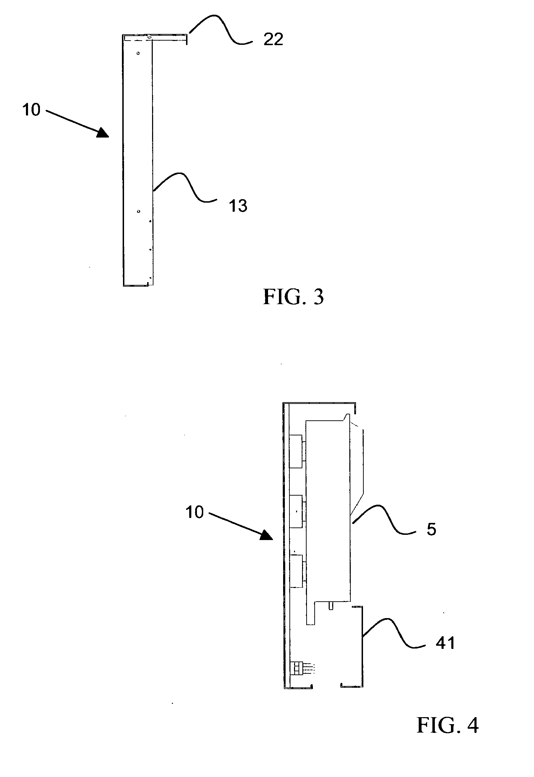

Figure 3 is a side view of an embodiment of the protective element 10 of the invention. The figure shows a side portion 13 bent from the rear portion. The upper portion of the protective element comprises a front portion 22 bent downward. The upper portion and its bent front portion 22 have been noticed to reduce the effect of the magnetic field considerably also on the open front portion of the protective element. The length of the downward bent front portion for example in a cabin having a length of about 900 mm is between 10 and 50 mm, preferably 20 and 40 mm and most preferably 25 and 35 mm. However, the length of the front portion 22 is to be adjusted according to the fittings to be placed inside the enclosure so that it does not interfere with the functioning of the fittings or their servicing/replacement.

Figure 4 is a partly cross-sectional view of the protective element of Figure 4 and the lower shield. It can be seen from the Figure how the arrangement covers the fitting 5, such as a series fuse. In the arrangement the protective element may be provided with a front shield element 41. The front shield element is meant to enhance the effect of the protective element and to provide protection against contact also below the fixture 5.

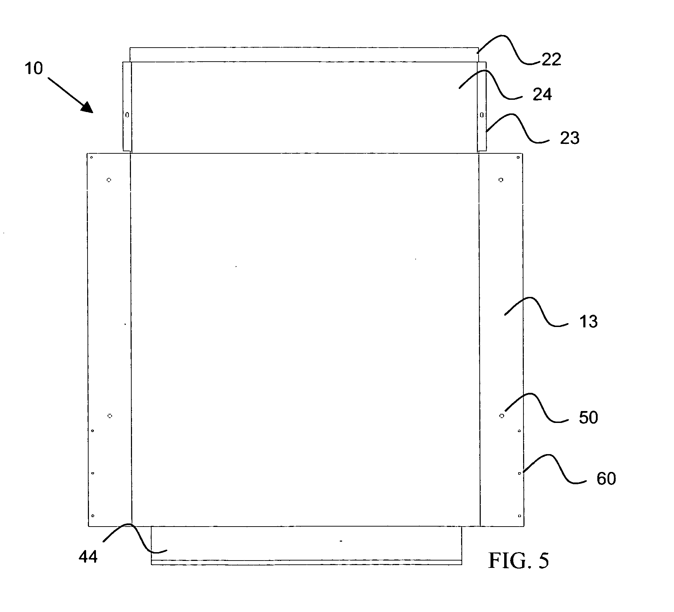

Figure 5 illustrates the protective element 10 of Figure 3 in its unbended form. The metal plate may be made of aluminium, for example. The upper portion of the protective element comprises side portions 23 bent downward. The width of the side portions 23 may be varied. The width shown in Figure 5 also provides added strength to the upper portion of the protective element 10.

The thickness of the protective element may be varied by changing the thickness of the metal plate. The thickness of the metal plate may vary; it may be 3 mm or 6 mm, for example. It is also possible to increase the thickness by placing metal plates one on top of the other, these superimposed plates being then bent into a desired form.

The rear portion of the protective element 10 comprises side portions 13 that are bent forward. The side portions 13 may be provided with holes 50, or the like, for fastening the protective element. In addition, the protective element may be provided with holes 60, or the like, for fastening the front shield element 41 of Figure 4. The protective element 10 further displays a lower shield 44. The protective element may be fastened to the base through the lower shield 44. In addition, the lower shield 44 strengthens the lower part of the structure of the protective element 10.

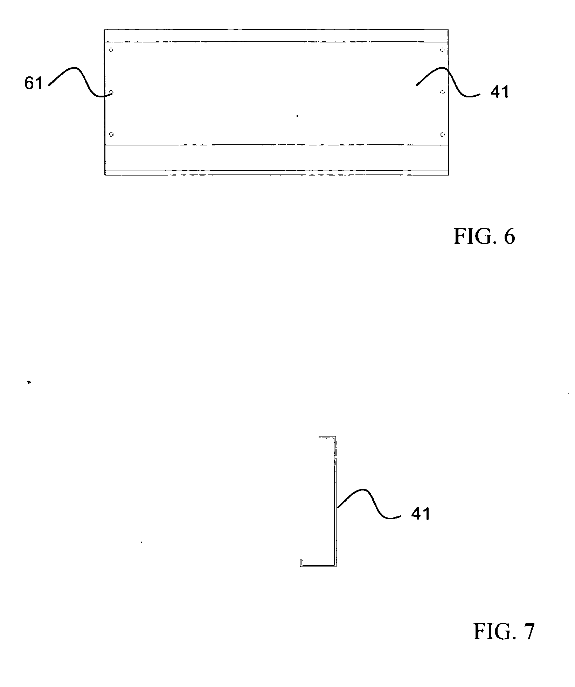

Figure 6 shows the front shield element 41 of Figure 4 in its unbended form and Figure 7 shows a side view of the front shield element 41 of Figure 7 in its bent form. The front shield element 41 is provided with holes, or the like, to fasten the bottom shield to the protective element. The front shield element may be fastened to the protective element by two parts to be attached to the sides (not shown), for example. The effect of the front shield piece provides protection against the magnetic field on the front side of the electrical cabinet and at a short distance from it. The protection provided by the front shield piece at a short distance contributes to protecting those working at the electrical cabinet against its magnetic field, primarily at the height of the PEN rail.

A person skilled in the art will find it obvious that as technology advances, the basic idea of the invention may be implemented in various ways. The invention and its embodiments are therefore not restricted to the above examples, but may vary within the scope of the claims.

## Claims

1. An electric power distribution cabinet comprising:
a busbar system;
fittings (5) like fuses or connectors arranged to the busbar system;
a housing part (3) enclosing the fittings (5), and provided with a front door opening through which coupling and maintenance work can be performed;
a shielding element placed between said housing part (3) and said fittings (5) for reducing magnetic fields caused by the electric power distribution cabinet (2),
the shielding element comprising:
a rear portion (11) arranged behind the fittings,
an upper portion (21) extending over the fittings,
**characterized in that**,
the shielding element (10) is made in one piece by bending a metal plate,
whereby the upper portion (21) further comprises a front portion (22) bent downward and which length is adjusted according to the fittings to be placed inside the enclosure so that it does not interfere with the functioning of the fittings and their servicing/replacement,
for reducing the magnetic field on the open front side of the shielding element.

2. The electric power distribution cabinet according to claim 1, **characterized in that** the upper portion (21) of the shielding element comprises side portions (23) bent downward.

3. The electric power distribution cabinet according to any one of the preceding claims, **characterized in that** the rear portion (11) of the shielding element comprises side portions (13) bent forward.

4. The electric power distribution cabinet according to any one of the previous claims, **characterized in that** the shielding element (10) is made by bending two or more superimposed pieces.

5. The electric power distribution cabinet according to claim 1, **characterized in that** the shielding element (10) is made of an aluminium plate.

6. The electric power distribution cabinet to claim 1, **characterized in that** on the front side, down between the housing part (3) and the fittings (5) there is arranged a metal front shield element (41) reducing the magnetic field.

7. The electric power distribution cabinet according to claim 1, **characterized in that** the length of the front portion (22) is between 10-50 mm.

## Patentansprüche

1. Elektroverteilerschrank mit:
einem Sammelschienensystem;
am Sammelschienensystem angeordneten Elektroinstallationen (5) wie Sicherungen oder Konnektoren;
einem Gehäuseteil (3), der die Elektroinstallationen (5) umschließt und mit einer Vordertüröffnung versehen ist, durch die Kopplungs- und Wartungsarbeiten durchgeführt werden können;
einem Abschirmelement, das zwischen dem besagten Gehäuseteil (3) und den besagten Elektroinstallationen (5) gestellt und für Reduzierung von durch den Elektroverteilerschrank (2) verursachten magnetischen Feldern vorgesehen ist,
welches Abschirmelement aufweist:
einen hinter den Elektroinstallationen angeordneten hinteren Abschnitt (11),
einen sich über die Elektroinstallationen erstreckenden oberen Abschnitt (21),
**dadurch gekennzeichnet, dass**
das Abschirmelement (10) durch Biegung einer Metallplatte einstückig ausgebildet ist,
wobei der obere Abschnitt (21) ferner einen nach unten gebogenen vorderen Abschnitt (22) aufweist und welche Länge nach den in die Umhüllung zu stellenden Elektroinstallationen eingestellt wird, so dass sie das Funktionieren der Elektroinstallationen und deren Wartung/Ersatzung nicht stört,
um das magnetische Feld auf der offenen Vorderseite des Abschirmelements zu reduzieren.

2. Elektroverteilerschrank nach Anspruch 1, **dadurch gekennzeichnet, dass** der obere Abschnitt (21) des Abschirmelements nach unten gebogene Seitenabschnitte (23) aufweist.

3. Elektroverteilerschrank nach einem der vorhergehenden Ansprüche, **dadurch gekennzeichnet, dass** der hintere Abschnitt (11) des Abschirmelements nach vorn gebogene Seitenabschnitte (13) aufweist.

4. Elektroverteilerschrank nach einem der vorhergehenden Ansprüche, **dadurch gekennzeichnet, dass** das Abschirmelement (10) durch Biegung von zwei oder mehr übereinanderliegenden Stücken hergestellt ist.

5. Elektroverteilerschrank nach Anspruch 1, **dadurch gekennzeichnet, dass** das Abschirmelement (10) aus einer Aluminiumplatte hergestellt ist.

6. Elektroverteilerschrank nach Anspruch 1, **dadurch gekennzeichnet, dass** auf der Vorderseite, unten zwischen dem Gehäuseteil (3) und den Elektroinstallationen (5), ein vorderes Abschirmelement (41) aus Metall angeordnet ist, das das magnetische Feld reduziert.

7. Elektroverteilerschrank nach Anspruch 1, **dadurch gekennzeichnet, dass** die Länge des vorderen Abschnitts (22) zwischen 10 und 50 mm ist.

## Revendications

1. Armoire de distribution d'électricité comprenant :
un système de barre-omnibus ;
des accessoires (5) tels que des fusibles ou connecteurs agencés sur le système de barre-omnibus ;
une partie logement (3) renfermant les accessoires (5), et pourvue d'une ouverture de porte avant par laquelle une tâche de couplage et d'entretien peut être réalisée ;
un élément de protection placé entre ladite partie logement (3) et lesdits accessoires (5) destiné à réduire les champs magnétiques provoqués par l'armoire de distribution d'électricité (2),
l'élément de protection comprenant :
une partie arrière (11) placée derrières les accessoires,
une partie supérieure (21) s'étendant sur les accessoires,
**caractérisé en ce que**,
l'élément de protection (10) n'est fabriqué que d'une seule pièce par pliage d'une plaque de métal,
moyennant quoi la partie supérieure (21) comprend en outre une partie avant (22) pliée vers le bas et dont la longueur est ajustée en fonction des accessoires à placer à l'intérieur de l'enceinte de sorte qu'elle n'interfère pas avec le fonctionnement des accessoires et l'entretien/remplacement,
pour réduire le champ magnétique sur le côté avant ouvert de l'élément de protection.

2. Armoire de distribution d'électricité selon la revendication 1, **caractérisée en ce que** la partie supérieure (21) de l'élément de protection comprend des parties latérales (23) pliées vers le bas.

3. Armoire de distribution d'électricité selon l'une quelconque des revendications précédentes, **caractérisée en ce que** la partie arrière (11) de l'élément de protection comprend des parties latérales (13) pliées vers l'avant.

4. Armoire de distribution d'électricité selon l'une quelconque des revendications précédentes, **caractérisée en ce que** l'élément de protection (10) est fabriqué par le pliage de deux, ou plus, pièces superposées.

5. Armoire de distribution d'électricité selon la revendication 1, **caractérisée en ce que** l'élément de protection (10) se compose d'une plaque d'aluminium.

6. Armoire de distribution d'électricité selon la revendication 1, **caractérisée en ce que**, sur le côté avant, en bas entre la partie logement (3) et les accessoires (5), se trouve un élément de protection avant métallique (41) réduisant le champ magnétique.

7. Armoire de distribution d'électricité selon la revendication 1, **caractérisée en ce que** la longueur de la partie avant (22) est comprise entre 10 et 50 mm.
